# EUROPEAN PATENT APPLICATION

(11) **EP 4 528 300 A1**
(43) Date of publication of application: **26.03.2025**
(21) Application number: 23199280.1
(22) Date of filing: 25.09.2023
(51) Int. Cl.: G01R 33/36

(54) **DETUNING OF MR COILS INVOLVING MONITORING OF A FIELD EFFECT TRANSISTOR SWITCH**

(71) Applicant: Koninklijke Philips N.V., 5656 AG Eindhoven (NL)
(72) Inventor: VERNICKEL, Peter, Eindhoven (NL); LEUSSLER, Christoph Günther, Eindhoven (NL); FINDEKLEE, Christian, 5656AG Eindhoven (NL)
(74) Representative: Philips Intellectual Property & Standards

(57) **Abstract**

The invention relates to a radio frequency receiver system (1) comprising
a radio frequency coil circuit (2),
a (de)tuning circuit (3) comprising a field effect transistor (4) configured to switch the radio frequency coil circuit (2) between an off ((de)tuned) and on (tuned) state,
a control source (5) configured to control the conductance of the field effect transistor (4) via a control signal,
wherein a first pole of the control source (5) is connected to the source of the field effect transistor (4) and a second pole of the control source (5) to the gate of the field effect transistor (4),
wherein the second pole of the control source (5) is connected to the drain of the field effect transistor (4) via a bypass (6), and
wherein the current and/or voltage in the bypass (6) is configured to be measured via a monitor circuit (12).
In this way, provide a a radio frequency receiver system (1) with improved characteristics is provided.

## Description

### FIELD OF THE INVENTION

The invention relates to the field of magnetic resonance imaging. In particular, the present invention relates to the field of radio frequency antenna systems for a magnetic resonance imaging device. The invention further relates to a radio frequency (RF) antenna or receiver assembly comprising an RF coil loop for pick-up of magnetic resonance signals, a (de)tuning circuit for switching the RF coil assembly between an off ((de)tuned) and on (tuned) state. The (de)tuning circuit includes a FET (field effect transistor)-based switch to switch the RF antenna assembly between the on and off states.

### BACKGROUND OF THE INVENTION

A part of every magnetic resonance imaging device is the radio frequency antenna system for receiving and converting the magnetic resonance signal. The radio frequency antenna system comprises a radio frequency coil, a matching network, a preamplifier and an optionally analog-to-digital converter. In magnetic resonance imaging the system integrated body coil generates the excitation magnetic field for the spin system causing a preceding relaxation. The precession of the net magnetization induces a current in the radio frequency coil via electromagnetic induction. The radio frequency coil comprises generally a conducting wire with an inductance and a coil resistance.
Like any radio frequency operated system, the radio frequency antenna system is subject to noise. Thereby, the most important requirement is to achieve a minimum noise figure to reduce image artifacts.

Magnet resonance (MR) coils for signal reception normally have two operational states: An ON-state which represents a low noise reception state for capturing of very weak (down to noise floor) nuclei signals. The other operational state is an OFF state which represents a passive state, in which the coils need to withstand strong RF pulses intended to excite nuclei. For switching, RF switches based on PIN diodes are usually applied. The detune circuit requires a bias current though the diode of typically in the order of 80mA. The supply of the detune circuit is then realized using a second feeding supply cable. This makes the cable tree of the coil less flexible and can generate instability of preamplifiers for RF coils. Furthermore, the control logic is expensive since the bias currents sum up to several Amperes in multi-channel coils in one of the operational phases. Strong losses have to be expected and the design of the feeding wires is challenging as the strong currents may not interfere with the static magnetic field B0 or gradient fields.

In more detail, besides other means, the on and off states are achieved by placing one or more detune switches along the coil conductors. Impedance transformation and transmission lines might be employed so that the actual switches can be placed at the same spot while they get effective at remote locations. Currently, the switch consists of a diode which is biased accordingly. Diodes available are far away from being an ideal switch exhibiting a non-zero forward-biased impedance and a non-infinite impedance when reverse biased. For MR, this issue is typically solved by adding a parallel resonant circuit with a switching diode as switch in series to the coil. The functioning of that circuit is detected by measuring the bias current though the diode continuously for patient and device safety When the two expected values of the bias current of the diode for "on" and "off'-state (zero and e.g. 80mA) are not reached a stop of the scan is triggered.

With the advent of (GaN) FET based switches, RF currents (induced by the RF transmit pulse) are effectively blocked in the coil loop without the need of high (de)tune currents. These newer (de)tune circuits are fully voltage controlled (typically 0/3V) and operate almost powerless in the two operational states of the coil.

For FETs there is no direct connection from the voltage control unit connected to the gate to the drain-source trace which is to be monitored for safety reasons. The straight-forward solution would be to add a second voltage/current driver connected via extra wires to the drain and source of the FETs. Monitoring the current/voltage of the source would enable the function check as for the diode. However, that doubles the amount of circuitry required per detune element and adds a number of extra cable connections which are in itself prone to fail.

### SUMMARY OF THE INVENTION

It is an object of the invention to provide a radio frequency antenna system with improved characteristics.

According to the invention, this object is addressed by the subject matter of the independent claims. Preferred embodiments of the invention are described in the sub claims.

The invention comprises a radio frequency receiver system comprising a radio frequency coil circuit, a (de)tuning circuit comprising a field effect transistor configured to switch the radio frequency coil circuit between an off ((de)tuned) and on (tuned) state, and a control source configured to control the conductance of the field effect transistor via a control signal, wherein a first pole of the control source is connected to the source of the field effect transistor and a second pole of the control source to the gate of the field effect transistor, and wherein the second pole of the control source is connected to the drain of the field effect transistor via a bypass, wherein the current and/or voltage in the bypass is configured to be measured via a monitor circuit.

The invention enables a desired functional monitoring without increasing the number of current voltage sources and separate wire connections. The principle is based on a bypass trace between the gate and drain terminals so that the control signal for the FET also passes though the drains source trace without affecting the functioning of the FET as a switch. The method provides an effective (de)tuning monitoring of a MRI coil loop. The bypass circuitry varies for different types of FETs. The invention proposes a solution for the bypass current considering depletion FETs as well as enhancement FETs in a detune circuits.

In case of an enhancement FET a resistor can be added as bypass between gate and drain. A positive control voltage over the gate source trace can put the FET in ON-state, effectively turning the coil off by means of the parallel resonant circuit. Simultaneously, the bypass can allow a certain DC current to flow through the drain source trace. This current can then be used to prove proper functioning of the switch. The resistor is preferably used symbolically to tailor the control voltage to the demands of the gate and the monitoring current. Setting a negative control voltage over the gate source trace can put the FET in OFF state. Consequently, no current should flow via the bypass resistor and the drain source trace. Detecting a substantial current can indicate malfunction, for instance a broken FET manifesting in a permanent short between drain and source terminal.

In case of a depletion FET, a diode can be inserted as a bypass. The control source can be realized in a way that it generates a bipolar voltage. Firstly, the negative voltage over the gate source trace, to put the FET in the OFF state, secondly a positive voltage over the gate source trace - typically >0.7V - bringing the FET in the ON-state. The diode is placed so that it prevents current in the OFF state (where the diode is reverse biased) and allows a current to flow in the on state. The diode is preferably used symbolically other components like resistors may be added to tailor the control voltage to the demands of the gate and the monitoring current. This enables to measure a monitoring current to demonstrate proper functioning of the FET. In the OFF state the diode prevents that that a negative voltage at the drain deteriorates switching performance of the FET. It is worth mentioning that in this circuitry a direct sensing of the high impedance of the FET in the OFF state is not possible.
Compared to the diode-based circuitry the monitoring current through the bypass can be several orders of magnitude lower than that for the switching diode (80 mA/100). This ensures that the aforementioned drawbacks of detune circuitry based on diodes as switching elements do not apply.

Preferably in the radio frequency receiver system the ratio of a first ohmic resistance in the bypass and a second ohmic resistance in the connection between the second pole of the control source and the gate of the field effect transistor is configured to adjust a gate voltage of the field effect transistor and/or the current in the bypass. Said ratio of ohmic resistances can be calculated according to Ohm's law and allows a cost-effective tuning of the circuit.

In another embodiment of the invention the radio frequency receiver system - in case the field effect transistor is a depletion field effect transistor - the bypass comprises a diode forward directed to the drain of the depletion field effect transistor. In this way the principle of the invention can be realized in an advantageous and cost-effective way.

Preferably the afore-mentioned diode in the radio frequency receiver system is configured to prevent that - above a predefined diode threshold voltage - a current flows through from the drain to the source of the depletion field effect transistor. For voltages below the FET threshold voltage, no current should flow for a properly functioning FET. Above the threshold voltage with conducting FET a current should be measurable. For instance, a negative voltage is applied to put the FET in an OFF state and a positive voltage - typically 0.7V - brings the FET in an ON-state. Hence knowing the specific threshold voltage of an FET can prevent current directions or signals that may cause noise or unwanted background for the measurements.

In a further embodiment of the invention the radio frequency receiver system has a diode which is configured to prevent that a negative voltage at the drain of the depletion field effect transistor deteriorates a switching performance of the depletion field effect transistor. In this way noise in the measurement system can be reduced and the measurement results can be improved.

Preferably in the radio frequency receiver system the connection of the first pole of the control source to the source of the field effect transistor comprises a low frequency pass and/or the bypass comprises a low frequency pass. In a further embodiment the low frequency pass is configured to block radio frequency currents. This allows for a separation of control currents from RF currents. The inductors (low passes) can prevent that RF signals reaching the DC pass. Further, for protection of the RF part from the DC influence, this can be performed by capacitors (high passes) in the corresponding circuit.

In another embodiment of the invention the radio frequency receiver system is configured to monitor the current in the bypass via one single wire in combination with a select/detune signal, especially of a select/detune signal of an MRI sequencer available in typical MRI systems. Preferably the aforementioned monitor circuit in the radio frequency receiver system is configured to detect a malfunction of the FET and/or a drift of a measured current and/or voltage. Said malfunction of the FET or even a drift of the measured voltage is usually sensitive to integrity, temperature or aging of the FET. An active monitor can compare the different measured voltages of all detune circuits and can calculate a baseline. A deviation from baseline or drifts can then be measured and stored and by activating a certain threshold, the monitor circuit - possibly including further electronics and/or logic - allows to report problems.

The proposed solution can also allow for the monitoring of a FET detune circuit without additional active devices and effects the efficiency of the RF detune switch only marginally, by typically less than <5%. One wire detune control and monitoring can further allow to realize lightweight and thin RF coils without fuses and reduces components for EMC with the body coil.

Preferably the radio frequency receiver system is configured to compare measured voltages and/or currents of multiple (de)tuning circuits and/or is configured to calculate average values. The monitor circuit can be realized fully analog or as a smart digital controller using a local artificial intelligence (AI) machine learning network for the monitor sensing. The monitor circuit can be controlled and supplied via a optical or wireless link. The monitor circuit can also be located in the coil, cable connector or in the patient's bed. AI based algorithms can for instance monitor trigger levels which may vary due to aging effects of the system's components and/or perform further smart analysis, especially for an exact prediction of the health and lifetime of specific system components like an FET and/or diode and/or inductor and/or capacitance.

In a further embodiment of the radio frequency receiver system the (de)tuning circuit is configured to be controlled by external (de)tune commands. This allows for more flexibility and a possibly central command of even more than one MRI system.

The invention further comprises a magnetic resonance imaging (MRI) system comprising a processor, a memory for storing machine executable instructions for execution by the processor and pulse sequence commands, and the radio frequency receiver system described above.

The invention further comprises a method for controlling a radio frequency receiver system comprising the following steps: detecting a radio frequency signal with a radio frequency coil circuit, switching the radio frequency coil circuit between an off ((de)tuned) and on (tuned) state with a detuning circuit, controlling the conductance of the field effect transistor via a control signal from a control source connected to the source and gate of the field effect transistor, measuring current and/or voltage in a bypass from the source and the drain of the field effect transistor via a monitor circuit, and comparing measured voltages and/or currents of multiple (de)tuning circuits and/or calculating average values. The method may further comprise the step of receiving the magnetic resonance signals from the radio frequency coil circuit with a pre-amplifier which sends an amplified signal to a reconstructor system.

The method for controlling a radio frequency receiver system can further comprise the steps of detecting a malfunction of the field effect transistor and/or a drift of a measured current and/or voltage via the monitor circuit.

### BRIEF DESCRIPTION OF THE DRAWINGS

These and other aspects of the invention will be apparent from and elucidated with reference to the embodiments described hereinafter. Such an embodiment does not necessarily represent the full scope of the invention, however, and reference is made therefore to the claims and herein for interpreting the scope of the invention.

In the drawings:
Fig. 1 schematically depicts a radio frequency antenna system according to the state of the art with a diode in the (de)tuning circuit.
Fig. 2 schematically depicts a radio frequency antenna system with a FET in the (de)tuning circuit 5 as illustration of the background of the invention.
Fig. 3 schematically depicts the radio frequency antenna system of Fig. 2 with a monitor circuit 12 2 as a further illustration of the background of the invention.
Fig. 4 schematically depicts a radio frequency antenna system according to a preferred embodiment of the invention with a bypass 6.
Fig. 5 schematically depicts a radio frequency antenna system according to a preferred embodiment of the invention with a bypass 6 for a depletion FET.

### DETAILED DESCRIPTION OF EMBODIMENTS

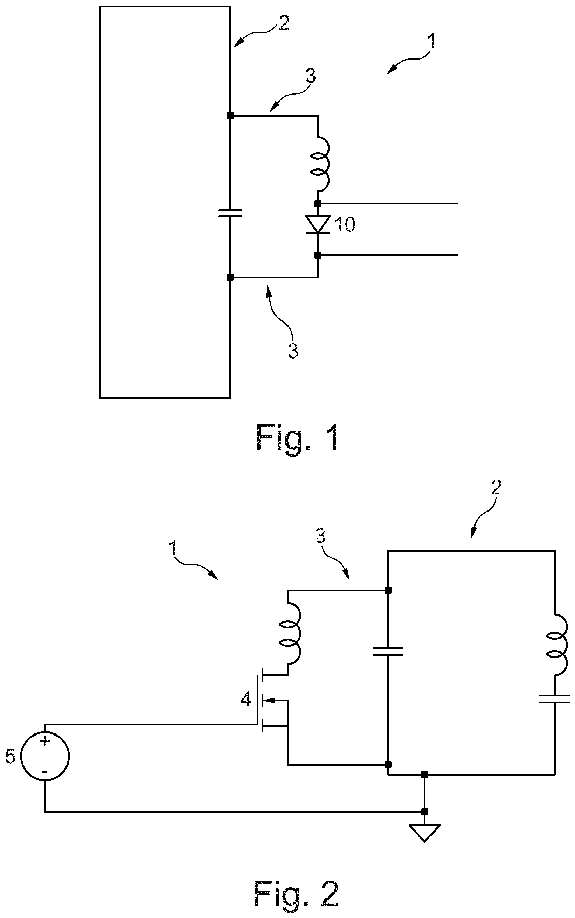

Figure 1 schematically depicts a radio frequency antenna system 1 according to the state of the art with a diode 10 in the (de)tuning circuit 3. The coil loop 2 is typically a resonator formed by a wire loop (an inductance) and at least one capacitor. In the ON-state of the MR coil, the diode 10 is reverse biased, disabling the inductance of the parallel resonant circuit. RF currents (induced from signals of the nuclei) can freely circulate in the coil loop. Mostly a capacitor or one of the capacitors forming the resonant circuit of the MR coil is double-used for that detune circuitry.

Being forward biased, the diode 10 enables the inductor forming a parallel resonant circuit together with that resonance capacitor. This provides a high blocking impedance, much higher than that of the reverse biased diode 10 itself. Radio frequency (RF) currents - induced usually by the RF transmit pulse - are effectively blocked in the coil loop preventing damage of the devices or a safety hazard for the patient. The MR coil is tuned "on" with the switch in OFF state and vice versa.

The functioning of that circuit is detected by measuring the bias current though the diode 10 continuously. When the two expected values for "on" and "off'-state (zero and e.g. 80mA) are not reached a stop of the scan is triggered. The issue with diodes 10 is that high steering currents are typically required adding to undesired coil heating and costs for creating the current. In a coil with many channels, the control current may add up to several Amperes.

One solution is to use FETs instead of diodes 10 as switching elements in the (de)tuning circuit 5 as shown in Figure 2 as illustration of the background of the invention. Devices with one or more FET fulfilling the detune requirements became recently available. With FETs, control of the state of the MR coil is performed with the gate voltage with basically zero current in both states, reducing the dissipation and power supply demands. Figure 2 further depicts the MR coil with a capacitor on the right and on the left, representing resonance capacitors, wherein the left capacitor is also used for the parallel resonant circuit 3 together with an inductance above the FET. The reference number 4 again represents the FET controlling the status together with a source 5.

Unlike for diodes the control current cannot be used for simultaneous control and monitoring. The control voltage affects the gate source trace while the proper functioning of the drain source trace needs to be monitored.

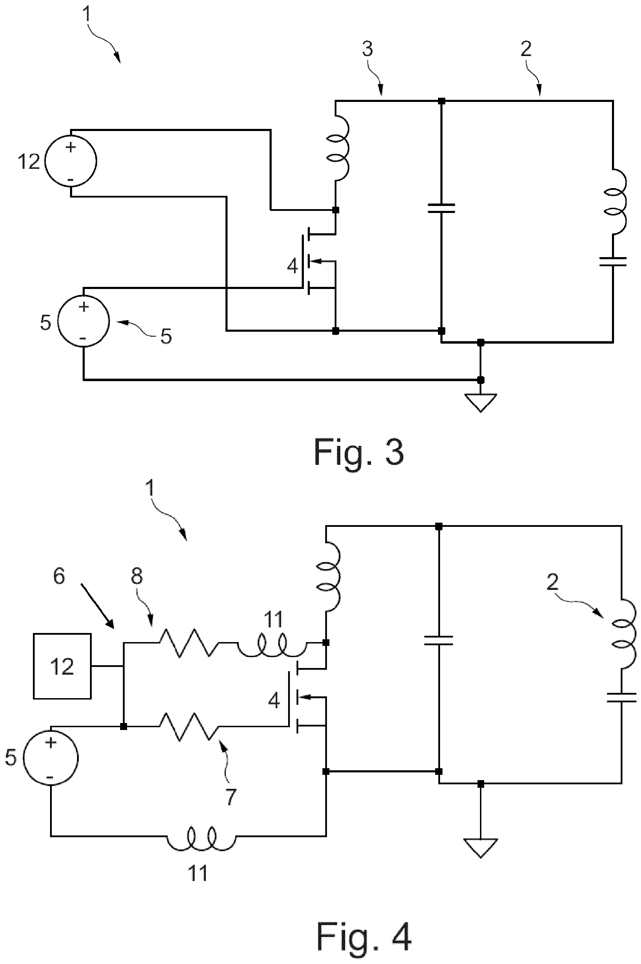

Figure 3 schematically depicts the radio frequency antenna system 1 of Fig. 2 as a further illustration of the background of the invention with a dedicated monitor circuit 12 for monitoring the drain source trace of the FET. However, this requires additional effort in making the monitor circuit 12 and the corresponding wiring.

Figure 4 schematically depicts a radio frequency antenna system 1 according to a preferred embodiment of the invention with a bypass 6. Figure 4 further shows the circuitry for an enhancement FET. The ohmic resistance 8 creates a current path from the control source 5 to the drain. For voltages below the FET threshold voltage, no current should flow for a properly functioning FET 4. Above the threshold voltage with conducting FET a current should be measurable. The ratio of the ohmic resistors 7 and 8 can be set to adjust gate voltage and sensing current requirements. The two elements with reference numbers 11 represent high frequency (HF) blockers or low pass filters to reduce RF currents in these circuits. A monitor circuit is connected or integrated in the (de)tune circuit.

In general, it needs to be considered that there are two types of FETs: A depletion FET, wherein the drain source trace is basically a short circuit when the gate voltage is zero or higher, the FET is switched off ("open") when the gate voltage is set below a (negative) threshold voltage. Referring to switch terminology used elsewhere, the switch is normally closed (NC). The second type is the enhancement FET, wherein the drain source trace is basically "open" or off when the gate voltage is zero, and the FET is switched on ("short") when the gate voltage is set above a (positive) threshold voltage.

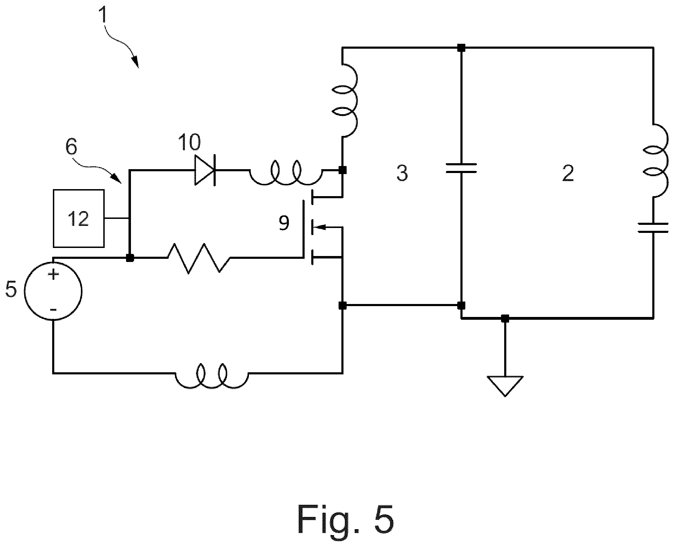

Figure 5 schematically depicts a radio frequency antenna system 1 according to a preferred embodiment of the invention with a bypass 6 for a depletion FET 9. For depletion FET the circuitry has a different layout due to the changed polarity of the threshold voltage. From the view of sensing the circuitry of the enhancement FET would work as well, but deteriorates the switching performance. (putting the negative voltage also on the drain). In Fig. 5 the ohmic resistance 8 has been replaced by a diode 10. The diode 10 prevents that the above 0.7V (the diode voltage) a current flows through the drain source trace, showing proper functioning of the FET 4 in that state. The diode 10 prevents that that a negative voltage at the drain deteriorates switching performance of the FET.

While the invention has been illustrated and described in detail in the drawings and foregoing description, such illustration and description are to be considered illustrative or exemplary and not restrictive; the invention is not limited to the disclosed embodiments. Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope. Further, for the sake of clearness, not all elements in the drawings may have been supplied with reference signs.

### REFERENCE SYMBOL LIST

| | |
|---|---|
| Radio frequency receiver system | 1 |
| Radio frequency coil circuit | 2 |
| (De)Tuning circuit | 3 |
| Field Effect Transistor / FET | 4 |
| Control source | 5 |
| Bypass | 6 |
| First ohmic resistance | 7 |
| Second ohmic resistance | 8 |
| Depletion field effect transistor | 9 |
| Diode | 10 |
| Low frequency pass | 11 |
| Monitor circuit | 12 |

## Claims

1. Radio frequency receiver system (1) comprising
a radio frequency coil circuit (2),
a (de)tuning circuit (3) comprising a field effect transistor (4) configured to switch the radio frequency coil circuit (2) between an off ((de)tuned) and on (tuned) state,
a control source (5) configured to control the conductance of the field effect transistor (4) via a control signal,
wherein a first pole of the control source (5) is connected to the source of the field effect transistor (4) and a second pole of the control source (5) to the gate of the field effect transistor (4),
wherein the second pole of the control source (5) is connected to the drain of the field effect transistor (4) via a bypass (6), and
wherein the current and/or voltage in the bypass (6) is configured to be measured via a monitor circuit (12).

2. Radio frequency receiver system according to claim 1, wherein the ratio of a first ohmic resistance (7) in the bypass (6) and a second ohmic resistance (8) in the connection between the second pole of the control source (5) and the gate of the field effect transistor (4) is configured to adjust a gate voltage of the field effect transistor (4) and/or the current in the bypass (6).

3. Radio frequency receiver system according to claim 2, wherein in case the field effect transistor (4) is a depletion field effect transistor (9), the bypass (6) comprises a diode (10) forward directed to the drain of the depletion field effect transistor (9).

4. Radio frequency receiver system according to claim 3, wherein the diode (10) is configured to permit that above a predefined diode threshold voltage a current flows through the drain to the source of the depletion field effect transistor (9).

5. Radio frequency receiver system according to claim 3, wherein the diode (10) is configured to prevent that a negative voltage at the drain deteriorates a switching performance of the depletion field effect transistor (9).

6. Radio frequency receiver system according to any of the preceding claims, wherein the connection of the first pole of the control source (5) to the source of the field effect transistor (4) comprises a low frequency pass (11) and/or wherein the bypass comprises a low frequency pass (11).

7. Radio frequency receiver system according to the preceding claim, wherein the low frequency pass (11) is configured to block radio frequency currents.

8. Radio frequency receiver system according to the preceding claim, wherein the radio frequency receiver system (1) is configured to monitor the current in the bypass (6) via one single wire in combination with a select/detune signal.

9. Radio frequency receiver system according to the preceding claim, wherein the radio frequency receiver system (1) is configured to detect a malfunction of the FET and/or a drift of a measured current and/or voltage via the monitor circuit (12).

10. Radio frequency receiver system according to the preceding claim, wherein the radio frequency receiver system (1) is configured to compare measured voltages and/or currents of multiple (de)tuning circuits (3) and/or is configured to calculate average values.

11. Radio frequency receiver system according to any of the preceding claims, wherein the (de)tuning circuit (3) is configured to be controlled by external (de)tune commands.

12. A magnetic resonance imaging system comprising
a processor,
a memory for storing machine executable instructions for execution by the processor and pulse sequence commands, and
a radio frequency receiver system (1) according to claim 1.

13. A method for controlling a radio frequency receiver system (1) comprising the following steps:
detecting a radio frequency signal with a radio frequency coil circuit (2),
switching the radio frequency coil circuit (2) between an off ((de)tuned) and on (tuned) state with a detuning circuit (5),
controlling the conductance of the field effect transistor (4) via a control signal from a control source (5) connected to the source and gate of the field effect transistor (4),
measuring current and/or voltage in a bypass (6) from the source and the drain of the field effect transistor (4) via a monitor circuit (12), and
comparing measured voltages and/or currents of multiple (de)tuning circuits (3) and/or calculating average values.

14. A method for controlling a radio frequency receiver system of claim 13, further comprising the steps of detecting a malfunction of the field effect transistor (4) and/or a drift of a measured current and/or voltage via the monitor circuit (12).
